# EUROPEAN PATENT APPLICATION

(11) **EP 2 270 599 A1**
(43) Date of publication of application: **05.01.2011**
(21) Application number: 10182696.4
(22) Date of filing: 27.04.2004
(51) Int. Cl.: G03F 7/20

(54) **Lithographic apparatus**

(30) Priority: 13.05.2003 EP 03252955; 22.10.2003 EP 03256643
(62) Divisional of application: 04252437.1
(71) Applicant: ASML Netherlands BV, 5504 DR Veldhoven (NL)
(72) Inventor: Streefkerk, Bob, 5038 PE, Tilburg (NL); Baselmans, Johannes, NL-5688 GG, Oirschot (NL); Cox, Henrikus, 5646 JH, Eindhoven (NL); Derksen, Antonius, 6813 EL, Arnhem (NL); Donders, Sjoerd, 5261 CA, Vught (NL); Hoogendam, Christiaan, 5563 AR, Westerhoven (NL); Lof, Joeri, 5616 BW, Eindhoven (NL); Loopstra, Erik, NL-5613 ES, Eindhoven (NL); Mertens, Jeroen, 5511 AM, Knegsel (NL); Van Der Meulen, Frits, 5646 JH, Breda (NL); Mulkens, Johannes, 5552 MA, Valkenswaard (NL); Van Nunen, Gerardus, 5351 CM, Berghem (NL); Simon, Klaus, 5655 CP, Eindhoven (NL); Slaghekke, Bernardus, 5502 PB, Veldhoven (NL); Straaijer, Alexander, 5644 KK, Eindhoven (NL); Van Der Toorn, Jan-Gerard, 5644 JB, Eindhoven (NL); Houkes, Martijn, 6135 JE, Sittard (NL)
(74) Representative: Maas, Abraham Johannes

(57) **Abstract**

A lithographic apparatus in which a localized area of the substrate surface under a projection system PL is immersed in liquid. The height of the liquid supply system 310 above the surface of the substrate W can be varied using actuators 314. A control system uses feedforward or feedback control with input of the surface height of the substrate W to maintain the liquid supply system 310 at a predetermined height above the surface of the substrate W.

## Description

The present invention relates to a lithographic projection apparatus and a device manufacturing method.

A lithographic apparatus is a machine that applies a desired pattern onto a target portion of a substrate. Lithographic apparatus can be used, for example, in the manufacture of integrated circuits (ICs). In that circumstance, a patterning means, such as a mask, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

It has been proposed to immerse the substrate in the lithographic projection apparatus in a liquid having a relatively high refractive index, e.g. water, so as to fill a space between the final element of the projection system and the substrate. The point of this is to enable imaging of smaller features since the exposure radiation will have a shorter wavelength in the liquid. (The effect of the liquid may also be regarded as increasing the effective NA of the system and also increasing the depth of focus.)

However, submersing the substrate or substrate and substrate table in a bath of liquid (see for example US 4,509,852, hereby incorporated in its entirety by reference) means that there is a large body of liquid that must be accelerated during a scanning exposure. This requires additional or more powerful motors and turbulence in the liquid may lead to undesirable and unpredictable effects.

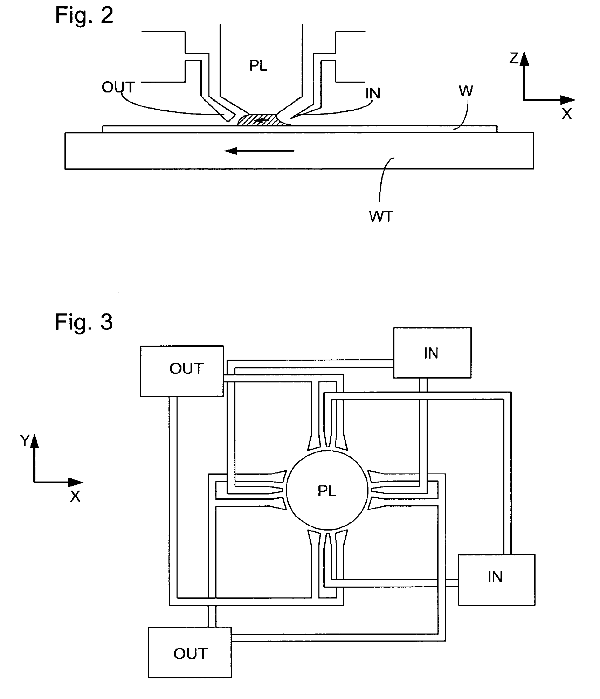

One of the solutions proposed is for a liquid supply system to provide liquid on only a localized area of the substrate and in between the final element of the projection system and the substrate using a liquid confinement system (the substrate generally has a larger surface area than the final element of the projection system). One way which has been proposed to arrange for this is disclosed in WO 99/49504, hereby incorporated in its entirety by reference. As illustrated in Figures 2 and 3, liquid is supplied by at least one inlet IN onto the substrate, preferably along the direction of movement of the substrate relative to the final element, and is removed by at least one outlet OUT after having passed under the projection system. That is, as the substrate is scanned beneath the element in a -X direction, liquid is supplied at the +X side of the element and taken up at the -X side. Figure 2 shows the arrangement schematically in which liquid is supplied via inlet IN and is taken up on the other side of the element by outlet OUT which is connected to a low pressure source. In the illustration of Figure 2 the liquid is supplied along the direction of movement of the substrate relative to the final element, though this does not need to be the case. Various orientations and numbers of in- and out-lets positioned around the final element are possible, one example is illustrated in Figure 3 in which four sets of an inlet with an outlet on either side are provided in a regular pattern around the final element.

Another solution which has been proposed is to provide the liquid supply system with a seal member which extends along at least a part of a boundary of the space between the final element of the projection system and the substrate table. The seal member is substantially stationary relative to the projection system in the XY plane though there may be some relative movement in the Z direction (in the direction of the optical axis). A seal is formed between the seal member and the surface of the substrate. Preferably the seal is a contactless seal such as a gas seal.

If the substrate is immersed in liquid as proposed, some residual liquid can remain on the surface of the substrate after it has been exposed by the projection system. This liquid can cause problems in subsequent processing of the substrate.

It is an object of the present invention to reduce the residual liquid left on the surface of a substrate after exposure by a projection system.

According to an aspect of the invention, there is provided a lithographic projection apparatus comprising:
- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate and having an optical axis; and
- a liquid supply system for providing an immersion liquid on said substrate in a space between the final element of said projection system and said substrate, **characterized in that**;
   at least part of said liquid supply system is free to move in the direction of the optical axis and/or rotate about at least one axis perpendicular to the optical axis.

The liquid supply system can therefore move relative to the surface of the substrate to accommodate changes in the surface height of the substrate without requiring a large clearance between the supply system and the substrate surface. The entire supply system or only those parts likely to come into contact with the surface of the substrate, such as a sealing member, may be moved. This is particularly useful when using a liquid supply system which provides liquid to only a localized area of the substrate. Also, the liquid supply system can be moved away from the substrate, for instance during a TIS scan, in the z direction and rotated about axes parallel to the x and y directions.

Preferably, the apparatus further comprises actuation means for adjusting the height and/or tilt of at least part of said liquid supply system relative to the substrate. This allows the height and/or tilt of the liquid supply system to be altered as required.

Preferably, the apparatus further comprises a control system for controlling said actuation means to maintain a predetermined height of said liquid supply system above said substrate. This ensures that the height of the liquid supply is maintained at a desired height. The height can be chosen to minimize the residue of the liquid left on the substrate as it is scanned under the projection system.

In one embodiment, the apparatus may further comprise at least one sensor for measuring a height of at least part of said liquid supply system above the surface of said substrate, and wherein said control system uses a feedback control method with input from said at least one sensor. The feedback control method allows the height to be controlled accurately based on the actual surface height of the substrate as it is scanned under the projection system.

In another embodiment, the apparatus may further comprise a measurement system for measuring a surface height of said substrate prior to the entry of said substrate into said projection system and for storing said measured height in a storage means, and wherein said control system uses feedforward control with input of said measured height from said storage means. If the surface height of the substrate is know prior to scanning of the substrate under the exposure system this data can be used for feedforward control of the height of the liquid supply system.

In another embodiment the apparatus may further comprise at least one sensor for measuring a height of said substrate in an exposure position, and wherein said control system uses a feedforward control method with input of said height of said substrate in an exposure position. The apparatus can then measure the height of the substrate as it is exposed by the projection system. This measurement can then be used as a feedforward input for when that part of the substrate passes under the liquid supply system. Alternatively a feedback control method can be employed.

Preferably, in the non-actuated state said actuation means positions said liquid supply system to its maximum setting away from the surface of said substrate in the direction of the optical axis of the projection system. This allows the control system to fail-safe. If the control signal is not supplied to the actuation means (i.e. it is in a non-actuated state) the supply system is not in danger of colliding with the substrate as the supply system is positioned as far away from the substrate's surface as possible but not so far so that immersion liquid escapes between the liquid supply system and the substrate.

Optionally, said actuation means is part of said liquid supply system, the actuation means comprising:
- a seal member extending along at least part of the boundary of said space between the final element of said projection system and said substrate table; and
   a gas seal means for forming a gas seal between said seal member and the surface of said substrate; and wherein the pressure in said gas seal is varied to adjust the height and/or tilt of said liquid supply system relative to the substrate. The gas seal acts to retain the liquid within the desired space and will also reduce the residue of liquid left on the substrate after it has been scanned under the projection system. The gas seal is also used to adjust the height of the liquid supply system, thereby simplifying construction as no dedicated actuator is required.

The actuator means may be connected between the liquid supply system and the base frame of the apparatus. Alternatively, the actuator may be connected between the liquid supply system and the reference frame of the apparatus. (The reference frame supports, *inter alia,* the projection system.)

Preferably, said predetermined height is in the range of 10 µm to 1000 µm. If the height is in the mentioned range the residual liquid remaining on the substrate after scanning is reduced. The height can also be varied according to the viscosity of the immersion liquid, or increased or decreased to increase/decrease the amount of liquid filling the space.

According to a further aspect of the invention there is provided a device manufacturing method comprising the following steps:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material; and
- providing a liquid on said substrate to fill a space between said substrate and a final element of a projection system used in said step of projecting;
   characterized by allowing the system which provides said liquid to move freely in the direction of the optical axis of said projection system.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm).

The term "patterning means" used herein should be broadly interpreted as referring to means that can be used to impart a projection beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit.

Patterning means may be transmissive or reflective. Examples of patterning means include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned. In each example of patterning means, the support structure may be a frame or table, for example, which may be fixed or movable as required and which may ensure that the patterning means is at a desired position, for example with respect to the projection system. Any use of the terms "reticle" or "mask" herein may be considered synonymous with the more general term "patterning means".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

Embodiments of the invention will now be described, by way of example only, with reference to the accompanying schematic drawings in which corresponding reference symbols indicate corresponding parts, and in which:
Figure 1 depicts a lithographic projection apparatus according to an embodiment of the invention;
Figure 2 depicts a side view of one proposed liquid supply system
Figure 3 depicts a plan view of the proposed liquid supply system shown in Figure 2;
Figure 4 depicts the liquid reservoir of the first embodiment of the invention;
Figure 5 is an enlarged view of part of the liquid reservoir of the first embodiment of the invention;
Figure 6 depicts the liquid reservoir of the second embodiment of the invention;
Figure 7 is an enlarged view of part of the liquid reservoir of the second embodiment of the invention;
Figure 8 depicts the liquid reservoir of the third embodiment of the invention; and
Figure 9 shows schematically the control of the liquid supply system and substrate table.

### EMBODIMENTS

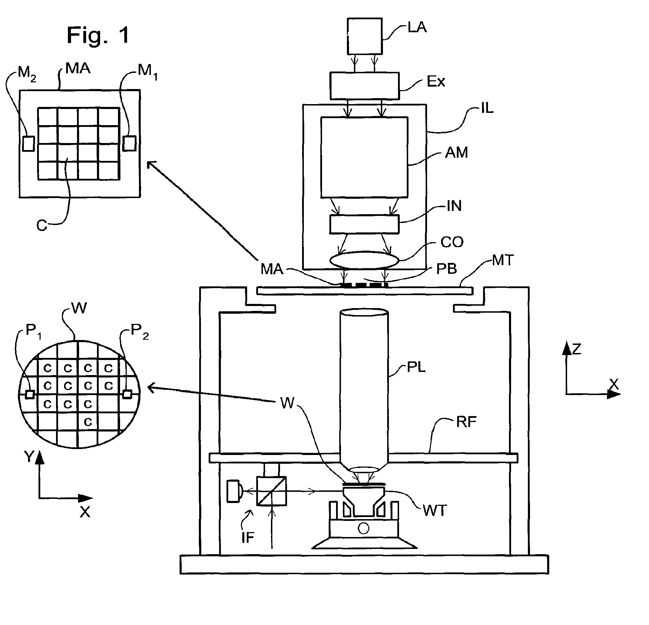

Figure 1 schematically depicts a lithographic apparatus according to a particular embodiment of the invention. The apparatus comprises:
- an illumination system (illuminator) IL for providing a projection beam PB of radiation (e.g. UV radiation).
- a first support structure (e.g. a mask table) MT for supporting patterning means (e.g. a mask) MA and connected to first positioning means PM for accurately positioning the patterning means with respect to item PL;
- a substrate table (e.g. a wafer table) WT for holding a substrate (e.g. a resist-coated wafer) W and connected to second positioning means PW for accurately positioning the substrate with respect to item PL; and
- a projection system (e.g. a refractive projection lens) PL for imaging a pattern imparted to the projection beam PB by patterning means MA onto a target portion C (e.g. comprising one or more dies) of the substrate W.

As here depicted, the apparatus is of a transmissive type (e.g. employing a transmissive mask). Alternatively, the apparatus may be of a reflective type (e.g. employing a programmable mirror array of a type as referred to above).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases the source may be integral part of the apparatus, for example when the source is a mercury lamp. The source SO and the illuminator IL, together with the beam delivery system BD if required, may be referred to as a radiation system.

The illuminator IL may comprise adjusting means AM for adjusting the angular intensity distribution of the beam. Generally, at least the outer and/or inner radial extent (commonly referred to as σ-outer and σ-inner, respectively) of the intensity distribution in a pupil plane of the illuminator can be adjusted. In addition, the illuminator IL generally comprises various other components, such as an integrator IN and a condenser CO. The illuminator provides a conditioned beam of radiation, referred to as the projection beam PB, having a desired uniformity and intensity distribution in its cross-section.

The projection beam PB is incident on the mask MA, which is held on the mask table MT. Having traversed the mask MA, the projection beam PB passes through the lens PL, which focuses the beam onto a target portion C of the substrate W. With the aid of the second positioning means PW and position sensor IF (e.g. an interferometric device), the substrate table WT can be moved accurately, e.g. so as to position different target portions C in the path of the beam PB. Similarly, the first positioning means PM and another position sensor (which is not explicitly depicted in Figure 1) can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning means PM and PW. However, in the case of a stepper (as opposed to a scanner) the mask table MT may be connected to a short stroke actuator only, or may be fixed. Mask MA and substrate W may be aligned using mask alignment marks M1, M2 and substrate alignment marks P1, P2.

The depicted apparatus can be used in the following preferred modes:
1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed.
   In step mode, the maximum size of the exposure field limits the size of the target portion C imaged in a single static exposure.
2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning means, and the substrate table WT is moved or scanned while a pattern imparted to the projection beam is projected onto a target portion C. In this mode, generally a pulsed radiation source is employed and the programmable patterning means is updated as required after each movement of the substrate table WT or in between successive radiation pulses during a scan. This mode of operation can be readily applied to maskless lithography that utilizes programmable patterning means, such as a programmable mirror array of a type as referred to above.

Combinations and/or variations on the above described modes of use or entirely different modes of use may also be employed.

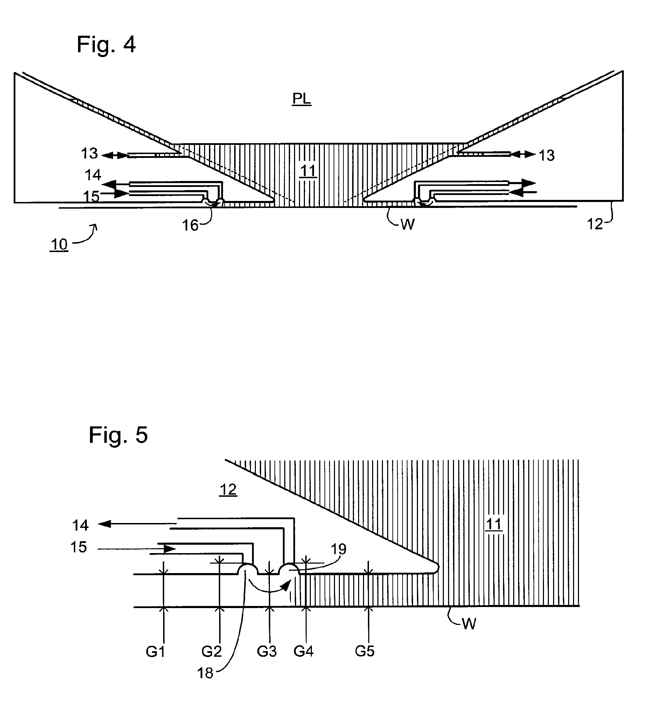

Figure 4 shows the liquid reservoir 10 between the projection system and the substrate stage which is described in detail in European Patent Application No. 03252955.4 hereby incorporated in its entirety by reference. The liquid reservoir 10 is filled with a liquid 11 having a relatively high refractive index, e.g. water, provided via inlet/outlet ducts 13. The liquid has the effect that the radiation of the projection beam has a shorter wavelength in the liquid than in air or a vacuum, allowing smaller features to be resolved. It is well known that the resolution limit of a projection system is determined, *inter alia,* by the wavelength of the projection beam and the numerical aperture of the system. The presence of the liquid may also be regarded as increasing the effective numerical aperture. Furthermore, at fixed numerical aperture, the liquid is effective to increase the depth of focus.

The reservoir 10 forms a contactless seal to the substrate around the image field of the projection system so that liquid is confined to fill a space between the substrate surface and the final element of the projection system. The reservoir is formed by a seal member 12 positioned below and surrounding the final element of the projection system PL. Liquid is brought into the space below the projection system and within the seal member 12. The seal member 12 extends a little above the final element of the projection system and the liquid level rises above the final element so that a buffer of liquid is provided. The seal member 12 has an inner periphery that at the upper end closely conforms to the step of the projection system or the final element thereof and may, e.g., be round. At the bottom, the inner periphery closely conforms to the shape of the image field, e.g., rectangular though this need not be the case.

The liquid is confined in the reservoir by a gas seal 16 between the bottom of the seal member 12 and the surface of the substrate W. The gas seal is formed by gas, e.g. air or synthetic air but preferably N₂ or another inert gas, provided under pressure via inlet 15 to the gap between seal member 12 and substrate and extracted via first outlet 14. The overpressure on the gas inlet 15, vacuum level on the first outlet 14 and geometry of the gap are arranged so that there is a high-velocity air flow inwards that confines the liquid. This is shown in more detail in Figure 5.

The gas seal is formed by two annular grooves 18, 19 which are connected to the first inlet 15 and first outlet 14 respectively by a series of small conducts spaced around the grooves. A large annular hollow in the seal member may be provided in each of the inlet and outlet to form a manifold. The gas seal may also be effective to support the seal member 12 by behaving as a gas bearing.

Gap G1, on the outer side of the gas inlet 15, is preferably small and long so as to provide resistance to air flow outwards but need not be. Gap G2, at the radius of the inlet 15, is a little larger to ensure a sufficient distribution of gas around the seal member, the inlet 15 being formed by a number of small holes around the seal member. Gap G3 is chosen to control the gas flow through the seal. Gap G4 is larger to provide a good distribution of vacuum, the outlet 14 being formed of a number of small holes in the same manner as the inlet 15. Gap G5 is small to prevent gas/oxygen diffusion into the liquid in the space, to prevent a large volume of liquid entering and disturbing the vacuum and to ensure that capillary action will always fill it with liquid.

The gas seal is thus a balance between the capillary forces pulling liquid into the gap and the airflow pushing liquid out. As the gap widens from G5 to G4, the capillary forces decrease and the airflow increases so that the liquid boundary will lie in this region and be stable even as the substrate moves under the projection system PL.

The pressure difference between the inlet, at G2 and the outlet at G4 as well as the size and geometry of gap G3, determine the gas flow through the seal 16 and will be determined according to the specific embodiment. However, a possible advantage is achieved if the length of gap G3 is short and absolute pressure at G2 is twice that at G4, in which case the gas velocity will be the speed of sound in the gas and cannot rise any higher. A stable gas flow will therefore be achieved.

The gas outlet system can also be used to completely remove the liquid from the system by reducing the gas inlet pressure and allowing the liquid to enter gap G4 and be sucked out by the vacuum system, which can easily be arranged to handle the liquid, as well as the gas used to form the seal. Control of the pressure in the gas seal can also be used to ensure a flow of liquid through gap G5 so that liquid in this gap that is heated by friction as the substrate moves does not disturb the temperature of the liquid in the space below the projection system.

The shape of the seal member around the gas inlet and outlet should be chosen to provide laminar flow as far as possible so as to reduce turbulence and vibration. Also, the gas flow should be arranged so that the change in flow direction at the liquid interface is as large as possible to provide maximum force confining the liquid.

The liquid supply system circulates liquid in the reservoir 10 so that fresh liquid is provided to the reservoir 10.

The gas seal 16 can produce a force large enough to support the seal member 12. Indeed, it may be necessary to bias the seal member 12 towards the substrate to make the effective weight supported by the seal member 12 higher. The seal member 12 will in any case be held in the XY plane (perpendicular to the optical axis) in a substantially stationary position relative to and under the projection system but decoupled from the projection system. The seal member 12 is free to move in the Z direction and can therefore move to accommodate changes in the surface height of the substrate.

One problem with the liquid supply system of this first embodiment is that when the substrate W is being moved shearing forces will try to move the penetration level of the liquid in the gap between the liquid supply system and the substrate either to the outside or to the inside (left or right as illustrated). Both are unwanted, to the outside may lead to leakage, to the inside may lead to air bubbles in the liquid. This can also happen as the height of the liquid supply system varies. One way to keep the liquid meniscus in a constant position is to monitor and actively control the position of liquid under the liquid supply system. The control may be implemented by locally increasing and decreasing the air and vacuum pressures in the seal 16.

The monitoring can be done in several ways. One way is by measuring the capacitance between neighbouring metal plates mounted on the bottom of the liquid supply system or by measuring the capacitance between such a plate and the substrate or substrate table. Another way is by measuring the magnetic properties of the medium, be it air or liquid. Since both the electrical as well as magnetic signals will scale with the liquid position an accurate positional measurement is possible.

When a conducting liquid like water is used, the conducting properties of the liquid can be used by having electrical contacts which are opened or closed. A minimum of two pairs of contacts are required one which should be open, one which should be closed. Sensing of closure or opening of the contacts will lead respectively to an increase or decrease in the air pressure of the gas seal or respectively decrease and increase the underpressure of the vacuum. If a smoother control is required the number of contacts can be increased.

Alternatively the effects of these shearing forces can be mitigated by adjusting the height and tilt of the seal member 12 either as described in this present embodiment or as described in embodiments 2 and 3 below. Also, it can be predicted that a height adjustment of the liquid supply system will induce movement of the meniscus and the pressure in the seal can be adjusted in a feedforward manner to account for this.

### Embodiment 2

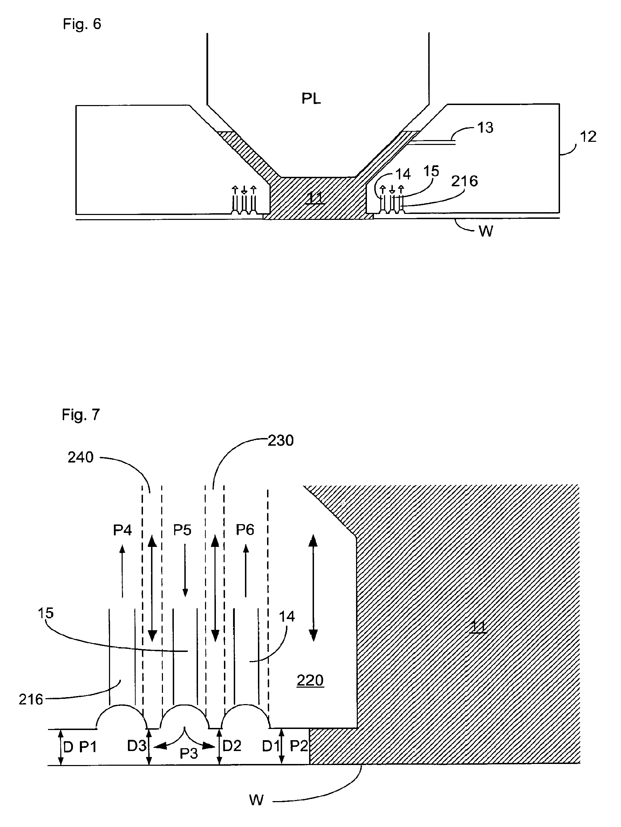

The second embodiment is illustrated in Figures 6 and 7 and is the same as the first embodiment except as described below.

In this embodiment a second gas outlet 216 is provided on the opposite side of the gas inlet 15 to the first gas outlet 14. In this way any gas escaping from the gas inlet 15 outwards away from the optical axis of the apparatus is sucked up by second gas outlet 216 which is connected to a vacuum source. In this way gas is prevented from escaping from the gas seal so that it cannot interfere, for example, with interferometer readings or with a vacuum in which the projection system and/or substrate are housed.

Another advantage of using the two gas outlet embodiment is that the design is very similar to that of air bearings previously used in lithographic projection apparatus. Thus the experience gained with those air bearings can be applied directly to the gas seal of this embodiment. The gas seal of the second embodiment is particularly suitable for use as gas bearing, as well as a seal means, such that it can be used to support the weight of the seal member 12.

Advantageously sensors may be provided to either measure the distance between the bottom face of the seal member 12 and the substrate W or the topography of the top surface of the substrate W. The sensors can be pneumatic, capacitive, optical (such as a level sensor or interferometer), electrical, magnetic, a combination of the foregoing or any other sensor. A control means may then be used to vary the pressures applied to the gas in- and out-lets 14, 15, 216 to vary the pressure P2 which constrains the liquid 11 in the reservoir and the pressures P1 and P3 which support the seal member 12. Thus the distance D between the seal member 12 and the substrate W may be varied or kept at a constant distance. The same control means may be used to keep the seal member 12 level. The control means may be controlled either by a feed forward or a feedback control loop. In a feedforward control system the measured topography of the top surface of the substrate is supplied as an input. The measurement can have taken place in a separate measurement step prior to the immersion of the substrate in the projection system, or can take place when as the image is projected to the target portion of the substrate. In a feedback control system a sensor measures the distance between the seal member 12 and the top surface of the substrate, this then forms the input to the control system.

Furthermore, the height of the liquid supply system above the substrate can be calculated from a knowledge of the position of the substrate table WT, the levelling map of the substrate made during the measurement step and the height of the liquid supply system relative to the lens PL, the metrology reference frame RF or the base frame BF.

Figure 7 shows in detail how the gas seal can be regulated to control independently the pressure P2 holding the liquid 11 in the reservoir and P3 which supports the seal member 12. This extra control is advantageous because it provides a way of minimizing liquid losses during operation, and hence the liquid residue remaining on the substrate after scanning. The second embodiment allows pressures P2 and P3 to be controlled independently to account for varying conditions during exposure. Varying conditions might be different levels of liquid loss per unit time because of different scanning speeds or perhaps because the edge of a substrate W is being overlapped by the seal member 12. This is achieved by providing means for varying the distance to the substrate W of discrete portions of the face of the seal member 12 facing the substrate W. These portions include the portion 220 between the first gas outlet 14 and the edge of the seal member 12 nearest the optical axis, the portion 230 between the gas inlet 15 and the first gas outlet 14 and the portion 240 between the second gas outlet 216 and the gas inlet 15. These portions may be moved towards and away from the substrate W by the use of piezoelectric actuators for example. That is the bottom face of the seal member 12 may comprise piezoelectric actuators (preferably stacks) which can be expanded/contracted by the application of a potential difference across them. Other mechanical means could also be used.

The pressure P3 which is created below the gas inlet 15 is determined by the pressure of gas P5 applied to the gas inlet 15, pressures of gas P6 and P4 applied to the first and second gas outlets 14 and 216 respectively and by the distance D between the substrate W and the bottom face of the seal member 12 facing the substrate W. Also the horizontal distance between the gas in and out-lets has an effect.

The weight of the seal member 12 is compensated for by the pressure of P3 so that the seal member 12 settles a distance D from the wafer W. A decrease in D leads to an increase in P3 and an increase in D will lead to a decrease in P3. Therefore this is a self regulating system.

Distance D, at a constant pushing force due to pressure P3, can only be regulated by pressures P4, P5 and P6. However, the combination of P5, P6 and D creates pressure P2 which is the pressure keeping the liquid 11 in the reservoir. The amount of liquid escaping from a liquid container at given levels of pressure can be calculated and the pressure in the liquid P_{LIQ} is also important. If P_{LIQ} is larger than P2, the liquid escapes from the reservoir and if P_{LIQ} is less than P2, air bubbles will occur in the liquid which is undesirable. It is desirable to try to maintain P2 at a value slightly less than P_{LIQ} to ensure that no bubbles form in the liquid but also to ensure that not too much liquid escapes as this liquid needs to be replaced. Preferably this can all be done with a constant D. If the distance D1 between portion 220 and the wafer W is varied, the amount of liquid escaping from the reservoir can be varied considerably as the amount of liquid escaping varies as a square of distance D1. The variation in distance required is only of the order of 1mm and this can easily be provided by a piezoelectric stack with an operational voltage of the order of 100V or more.

Alternatively, the amount of liquid which can escape can be regulated by placing a piezoelectric element at the bottom of portion 230. Changing the distance D2 is effective to change pressure P2. However, this solution might require adjustment of pressure P5 in gas inlet 15 in order to keep D constant.

The piezoelectric elements are connected so that when no control signal is applied to them, the supply member is positioned above the substrate. This allows the chance of damage in the event of a malfunction to be reduced; when no signal is supplied the seal member is positioned above the substrate surface and so cannot collide with it.

Of course the distance D3 between the lower part of portion 240 and substrate W can also be varied in a similar way and can be used to regulate independently P2 and P3. It will be appreciated that pressures P4, P5 and P6 and distances D1, D2 and D3 can all be regulated independently or in combination to achieve the desired variation of P2 and P3.

Indeed the second embodiment is particularly effective for use in active management of the quantity of liquid in the reservoir 10. The standby situation of the projection apparatus could be, where no substrate W is being imaged, that the reservoir 10 is empty of liquid but that the gas seal is active thereby to support the seal member 12. After the substrate W has been positioned, liquid is introduced into the reservoir 10. The substrate W is then imaged. Before the substrate W is removed the liquid from the reservoir can be removed. After exposure of the last substrate the liquid in the reservoir 10 will be removed. Whenever liquid is removed, a gas purge has to be applied to dry the area previously occupied by liquid. The liquid can obviously be removed easily in the apparatus according to the second embodiment by variation of P2 whilst maintaining P3 constant as described above. In other embodiments a similar effect can be achieved by varying P5 and P6 (and P4 if necessary or applicable).

### Embodiment 3

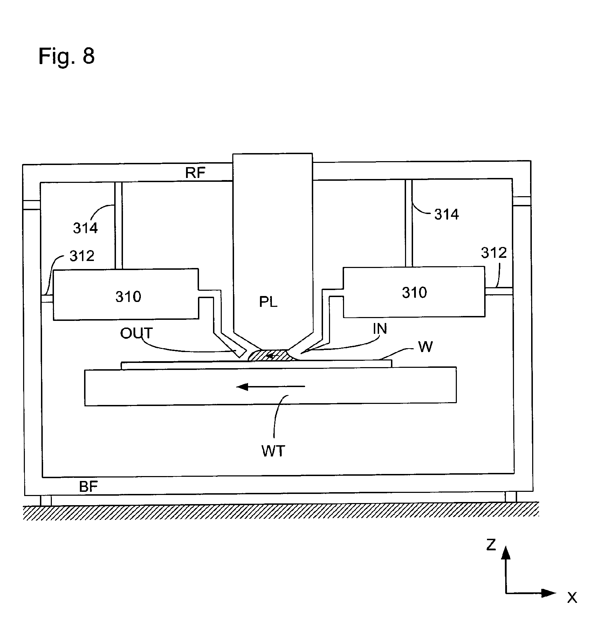

A third embodiment of the invention is illustrated in Figure 8. The construction of this embodiment is the same as the first or second embodiment, save as described below.

In this embodiment liquid is supplied by at least one inlet IN and removed by at least one outlet OUT which make up a liquid confinement system as described in relation to figures 2 and 3, for example. The liquid is supplied and taken up in the same direction as the scanning direction of the substrate. The liquid supply and take-up system 310, is positioned horizontally in the X-Y plane, parallel to the surface of the substrate, by supporting members 312 which connect the supply and take-up system 310 to a base frame BF. Supporting members 312 may be actuators so that if the projection system moves in the X-Y plane, the liquid supply system can be held substantially stationary relative to the projection system PL in the X-Y plane. A further set of actuators 314 connected between the liquid supply and take-up system 310 and a reference frame RF which also supports the projection system PL. These actuators 314 control the vertical position in the Z direction, parallel to the optical axis of the projection system. However, the liquid supply system could be attached to only one of the reference RF and base BF frames or both and the functions of the connections to those frames could be reversed from what is described above. The actuators 314 can be piezoelectric, Lorentz motors, excenter mechanisms, linear (electrical, magnetic or a combination) or other actuators. In the situation where no signal is supplied to the actuators, the supply and take-up system 310 is positioned above the substrate to reduce the risk of collision. A signal must be supplied to the actuators to move the supply and take-up system 310 closer to the surface of the substrate. The verticle movement possible is preferably of the order of several hundred microns.

In use a feedforward or feedback control system (as described for the above embodiments) controls the actuators 314 to maintain the liquid supply and take-up system at a predetermined height above the surface of the substrate. This enables the clearance to be small if desired, enabling the liquid residue remaining on the substrate after scanning to be reduced without increasing the risk of collision.

The actuators 314 can also be connected between the supply and take-up system 310 and the projection system PL or the base frame BF. The actuators can also act in combination with the pneumatic or piezoelectric systems described above for the first and second embodiments.

Of course, the vertical positioning system of this embodiment can also be used to position the sealing member of the liquid confinement systems described in the above first and second embodiments and illustrated in figures 4 to 7. In that case, it is not necessary to have inlet 15 and the seal between the seal member 12 and the substrate W can be provided by vacuum through outlet 14 only. However, providing an air flow through inlet 15 can be used as a safety feature to provide an air cushion between the liquid supply system and the substrate. In this case it can be useful to have sensors 20 positioned on the barrier member 12 preferably in a bottom surface of the barrier member 12 radially outwardly of the seal means 16. The sensors may be an air gage, or a capacitive sensor etc.. As with the embodiment of Figure 8, it is also possible to measure the difference in the distance between the liquid supply system and the reference frame RF or the base frame BF and the substrate table WT and the same frame.

An embodiment with the seal member of the first or second embodiment where no gas seal 16 is present between the seal member 12 and the substrate W is also possible. In this case liquid is allowed to leak between the seal member 12 and the substrate W. Such a seal member is disclosed, for example, in USSN 10/743,271 hereby incorporated in its entirety by reference.

The present invention cannot only be used to maintain the distance between the liquid supply system and the substrate but can also be used to move the liquid supply system out of the way during substrate swap. This is particularly so if a closure disk is used in which a disk is placed under the projection system to act as a dummy substrate so that the liquid supply system does not need to be switched off during substrate swap. Such a system is disclosed in European Patent Application No. 03254059.3, hereby incorporated in its entirety by reference. In this way the liquid supply system may be moved away from the substrate table WT during substrate swap thereby reducing cycle time.

### Control Program for Actuated Barrier Member or Liquid Supply System

The following description assumes that the height of the liquid supply system above the substrate table WT is measured by comparing the distance of the liquid supply system to the metrology reference frame MT with the distance of the substrate table WT from the metrology reference frame MT. However, the same control program can be used if the height of the liquid supply system above the substrate table WT is measured directly or if the height is measured indirectly by reference to any other point or part of the apparatus.

One of the greatest hazards of an immersion lithography machine is loosing control of the machine resulting in collision between the liquid supply system and the substrate or the substrate table, particularly if TIS sensors or positioning mirror blocks are on the table WT as they can be scratched by collision with the liquid supply system. In order to alleviate this hazard, it is proposed to continuously monitor the gap between the liquid supply system and the substrate table WT, as mentioned above. This position signal is differentiated to obtain a relative velocity signal.

The liquid supply system and substrate table WT geometries are arranged such that in its uppermost position the liquid supply system cannot collide with the substrate table in its uppermost position. Conversely, in the lowest position the liquid supply system can obtain, the substrate table WT can be moved to an even lower position where collision with the liquid supply system cannot occur. Furthermore, the actuators of the substrate table are arranged so that a larger acceleration of the substrate table WT downwards can be achieved than the maximum acceleration of the liquid supply system downwards. If a large acceleration of the liquid supply system towards the substrate table is detected, the substrate table WT is accelerated away from the liquid supply system to its lowest position where it is safe from the liquid supply system. Also if the substrate table WT suddenly starts accelerating towards the liquid supply system the liquid supply system is accelerated with a much larger acceleration away from the substrate table WT. The converse is also true so that the maximum acceleration of the liquid supply system is greater than the substrate table in the upwards direction but much lower than that of the substrate table in the downwards direction.

All of the sensors involved in this control are monitored and processed in hardware which is independent of the normal motion control hardware and software. If any of the signals from the sensors fails, the liquid supply system is automatically moved to its upper most position, for example, by a mechanical spring. This mechanical spring (or perhaps magnetic force) also works if there is a power failure to the system.

Simple precautions are also taken such as only activating the liquid supply system if scanning control has started. Furthermore, another situation which may arise is that the relative velocity of the liquid supply system to the substrate table WT is too high. In this case both the liquid supply system and the substrate table WT are stopped. If the relative velocity is within acceptable limits but the distance between the liquid supply system and the substrate table WT becomes too small, the actuators are also stopped. If the relative velocity and position are both within acceptable limits, normal operation is allowed.

It may sometimes be necessary to override the safety algorithm, for example, during attaching of a closure disk as described above. The closure disk is positioned on the substrate table WT so that it is necessary to bring the liquid supply system into close proximity of the closure disk which requires overriding of the above described safety algorithm. It may only be necessary to disable the position check of the above described safety algorithm but to maintain the velocity check.

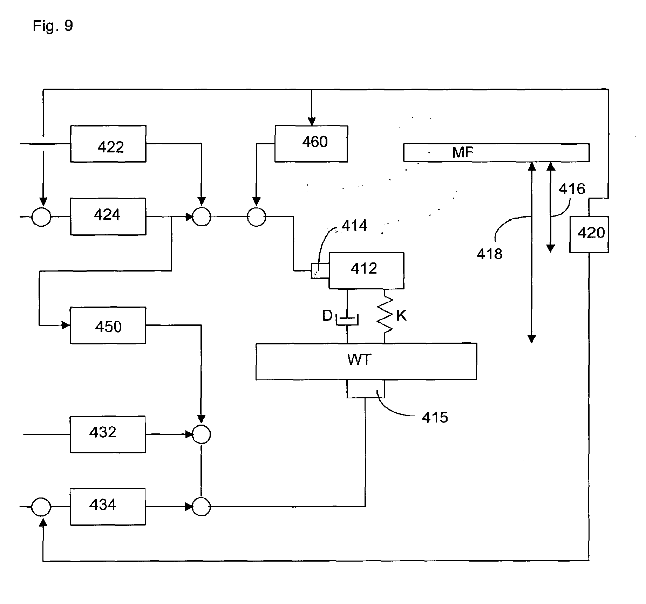

Figure 9 illustrates schematically the control loops for the present invention. A liquid supply system 412, preferably of the barrier member type, is provided with an actuator system 414 comprising three actuators to enable actuation in the z, Rx and Ry directions. The actuators may be, for example, Lorentz actuators with permanent magnet systems used for gravity compensation. The barrier member 412 is constrained by connectors to the base frame BF, reference frame RF or metrology reference frame MF in the x y plane.

Actuator 415 is for actuating the substrate table WT in the z direction. The relative positions of the liquid supply system 412 and the substrate table WT are measured by measuring the relative positions of the substrate table WT to the metrology reference frame MF (distance 418) and between the liquid supply system 412 and the metrology reference frame MF (416). A processor 420 processes this information and supplies it to various other controllers as described below. The information contains at least information about the relative positions of the liquid supply system 412 and the substrate table WT and may also contain other information such as the distance 418 and/or 416 as well as perhaps the time differential of any of those distances which equate to the relative velocity of the two objects and to the absolute velocity of the substrate table WT and the liquid supply system 412 respectively.

A schematic damper D and spring K are illustrated acting between the liquid supply system 412 and substrate table WT. These are representative of the properties of the immersion liquid which transmits forces between the liquid supply system 412 and the substrate table WT. From a knowledge of the physical properties of the immersion liquid and the geometry of the liquid in the liquid supply system 412 and the geometry of the liquid supply system 412 itself, it is possible to calculate the likely damping coefficient D and spring constant K. As will be described below, knowledge of this can be used to either design the geometry of the liquid supply system 412 to increase D to an extent such that the transmission of forces between the liquid supply system 12 and the substrate table WT is filtered or to compensate for the damping coefficient D and spring constant K when actuating the liquid supply system 412 through actuator 414.

The standard control system for both the actuator 414 for the liquid supply system 412 and for the actuator 415 for the substrate table WT comprises a positional controller which receives a signal representative of the desired position of the showerhead or substrate table (the positional controller is labelled 424 and 434 for the liquid supply system 412 and the substrate table WT respectively) as well as an acceleration controller which receives a signal representative of the desired acceleration of the liquid supply system 412 or substrate table WT (which are labelled 422 and 432 respectively).

As can be seen from Figure 9, the positional controllers 424, 423 receive a signal from the processor 420 representative of positional information regarding substrate table WT and the liquid supply system 412.

Two further elements are provided in the control system for improving the performance thereof. The first of these is a filtered feed-forward compensator 450 which is equal to the output of the liquid supply system positional controller 424 but is preferably such a signal which has been filtered to correct for the closed loop characteristics of the liquid supply system 412.

The other additional element is a compensator 460 which compensates the output of the positional controller 424 and acceleration controller 422 for the stiffness K and damping coefficient D of the immersion liquid between the liquid supply system 412 and substrate table WT. This controller reduces the forces transmitted between the liquid supply system 412 and the substrate table WT due to removal of liquid and gas by the liquid supply system 412. Transmission of these forces can be a particular problem with barrier type liquid supply systems 412 with a gas seal as described in embodiments 1 and 2 above.

The present inventors have found that if the input to the actuator 414 of the liquid supply system 412 has a low band width (between 10 and 30 Hz) and the damping coefficient D is above about 1 x 10³ N/(m/s) the performance of the lithography machine can be improved. This is achieved by mechanical design and therefore very cost effective. Calculations have shown that for an immersion liquid thickness of 0.1 mm the area of liquid constrained by the liquid supply system on the substrate W should be in the region of 8,000 mm².

In the above description, reference is made to the substrate table WT. This could be the fine positioning upper element of a substrate table comprised of an upper fine positioning element and a lower coarse positioning element or a combination of both elements or of only the coarse element or any other suitable element of the substrate positioning mechanism of the apparatus.

Whilst specific embodiments of the invention have been described above, it will be appreciated that the invention may be practiced otherwise than as described. The description is not intended to limit the invention. preferably such a signal which has been filtered to correct for the closed loop characteristics of the liquid supply system 412.

The other additional element is a compensator 460 which compensates the output of the positional controller 424 and acceleration controller 422 for the stiffness K and damping coefficient D of the immersion liquid between the liquid supply system 412 and substrate table WT. This controller reduces the forces transmitted between the liquid supply system 412 and the substrate table WT due to removal of liquid and gas by the liquid supply system 412. Transmission of these forces can be a particular problem with barrier type liquid supply systems 412 with a gas seal as described in embodiments 1 and 2 above.

The present inventors have found that if the input to the actuator 414 of the liquid supply system 412 has a low band width (between 10 and 30 Hz) and the damping coefficient D is above about 1 x 103 N/(m/s) the performance of the lithography machine can be improved. This is achieved by mechanical design and therefore very cost effective. Calculations have shown that for an immersion liquid thickness of 0.1 mm the area of liquid constrained by the liquid supply system on the substrate W should be in the region of 8,000 mm2. In the above description, reference is made to the substrate table WT. This could be the fine positioning upper element of a substrate table comprised of an upper fine positioning element and a lower coarse positioning element or a combination of both elements or of only the coarse element or any other suitable element of the substrate positioning mechanism of the apparatus.

Whilst specific embodiments of the invention have been described above, it will be appreciated that the invention may be practiced otherwise than as described. The description is not intended to limit the invention.
Clause 1. A lithographic projection apparatus comprising:
   - a radiation system for providing a projection beam of radiation;
   - a support structure for supporting patterning means, the patterning means serving to pattern the projection beam according to a desired pattern;
   - a substrate table for holding a substrate;
   - a projection system for projecting the patterned beam onto a target portion of the substrate and having an optical axis; and
   - a liquid supply system for providing an immersion liquid on said substrate in a space between the final element of said projection system and said substrate,
      **characterized in that**;
      at least part of said liquid supply system is free to move in the direction of the optical axis and/or rotate about at least one axis perpendicular to the optical axis.
Clause 2. An apparatus according to clause 1, further comprising actuation means for adjusting the height and/or tilt of at least part of said liquid supply system relative to the substrate.
Clause 3. An apparatus according to clause 2, further comprising a control system for controlling said actuation means to maintain a predetermined height of at least part of said liquid supply system above said substrate.
Clause 4. An apparatus according to clause 3, further comprising at least one sensor for measuring a height of at least part of said liquid supply system above the surface of said substrate, and wherein said control system uses a feedback control method with input from said at least one sensor.
Clause 5. An apparatus according to clause 3, further comprising a measurement syste for measuring a surface height of said substrate prior to the entry of said substrate into said projection system and for storing said measured height in a storage means, and wherein said control system uses feedforward control with input of said measured height from said storage means.
Clause 6. An apparatus according to clause 3, further comprising at least one sensor for measuring a height of said substrate in an exposure position, and wherein said control system uses a feedforward control method with input of said height of said substrate in an exposure position.
Clause 7. An apparatus according to any one of clause 2 to 6, wherein in the nonactuated state said actuation means positions said liquid supply system to its maximum setting away from the surface of said substrate in the direction of the optical axis of the projection system.
Clause 8. An apparatus according to any one of clauses 2 to 7, wherein said actuation means is connected between said liquid supply system and a base frame which supports said substrate table and/or a reference frame which supports said projection system.
Clause 9. An apparatus according to clause 8, wherein supporting members or further actuations means are connected between said liquid supply system and said base frame and/or reference frame for keeping said liquid supply system substantially stationary relative to the projection system in the plane perpendicular to the optical axis.
Clause 10. An apparatus according to any one of clauses 2 to 6, wherein said actuation means is part of said liquid supply system, the actuation means comprising:
   - a seal member extending along at least part of the boundary of said space between the final element of said projection system and said substrate table; and
   - a gas seal means for forming a gas seal between said seal member and the surface of said substrate; and wherein the pressure in said gas seal is varied to adjust the height and/or tilt of said liquid supply system relative to the substrate.
Clause 11. An apparatus according to clause 10, further comprising at least one sensor formeasuring the position of the edge of said liquid relative to said gas seal means and a controller for varying said pressure in said gas seal means to influence said position of the edge of said liquid.
Clause 12. An apparatus according to clause 11, wherein said controller operates in a feedforward manner, based on the distance between said seal member and said substrate.
Clause 13. An apparatus according to any one of clauses 3 to 12, wherein said predetermined height is in the range of 10 µm to 1000 µm
Clause 14. An apparatus according to any one of the preceding clauses, further comprising a dummy disk for positioning under said liquid supply system during substrate swap, wherein said dummy disk is attachable to said at least part of said liquid supply system and said at least part of said liquid supply system is movable away from said substrate with said dummy disk attached during substrate swap.
Clause 15. An apparatus according to any one of the preceding clauses, wherein said part of said liquid supply system is braced away from said substrate table, preferably by a nonelectrical mechanical or magnetic means.
Clause 16. An apparatus according to any one of the preceding clauses, further comprising a safety controller which monitors the relative positions and/or velocity of said part of said liquid supply system and said substrate table.
Clause 17. An apparatus according to clauses 16, wherein said safety controller can control movement of said part of said liquid supply system and/or substrate table in the event of a collision risk being determined from said monitoring thereby to prevent said collision.
Clause 18. An apparatus according to any one of the preceding clauses, further comprising a positional controller for generating control signals for positioning of said part of saidliquid supply system in the direction of the optical axis.
Clause 19. An apparatus according to clause 18, wherein said positional controller is also for generating control signals for the positioning of said substrate table in the direction of the optical axis.
Clause 20. An apparatus according to clause 19, further comprising a feedforward compensator for compensating said control signals for the positioning of said substrate table based on said control signals for positioning of said part of said liquid supply system.
Clause 21. An apparatus according to clause 20, wherein said compensator compensates for the closed loop characteristics of said part of said liquid supply system.
Clause 22. An apparatus according to any one of the preceding clauses 19 to 21, further comprising a damping and stiffness compensator for compensating said control signals for positioning of said part of said liquid supply system to mitigate for the damping coefficient and stiffness of immersion liquid between said liquid supply system and said substrate.
Clause 23. An apparatus according to any one of the preceding clauses, wherein at least part of said liquid supply system is free to rotate around the axes orthogonal to the optical axis.
Clause 24. A device manufacturing method comprising the steps of:
   - providing a substrate that is at least partially covered by a layer of radiation sensitive material;
   - providing a projection beam of radiation using a radiation system;
   - using patterning means to endow the projection beam with a pattern in its cross-section;
   - projecting the patterned beam of radiation onto a target portion of the layer of radiation-sensitive material, and
   - providing a liquid on said substrate to fill a space between said substrate and a final element of a projection system used in said step of projecting,
      characterized by allowing the system which provides said liquid to move freely in the direction of the optical axis of said projection system.

## Claims

1. A lithographic projection apparatus comprising:
a substrate table for holding a substrate;
a projection system for projecting a patterned beam onto a target portion of the substrate and having an optical axis; and
a liquid supply system for providing an immersion liquid on said substrate in a space between the final element of said projection system and said substrate, **characterized in that**;
the apparatus further comprises actuation means for adjusting the tilt of at least part of said liquid supply system relative to the substrate.

2. The apparatus of claim 1, wherein the actuation means is for adjusting the height of at least part of the liquid supply system relative to the substrate.

3. An apparatus according to claims 1 or 2, wherein in the non-actuated state said actuation means positions said liquid supply system to its maximum setting away from the surface of said substrate in the direction of the optical axis of the projection system.

4. An apparatus according to any preceding claim, wherein said actuation means is connected between said liquid supply system and a base frame which supports said substrate table and/or a reference frame which supports said projection system.

5. An apparatus according to claim 4, wherein supporting members or further actuations means are connected between said liquid supply system and said base frame and/or reference frame for keeping said liquid supply system substantially stationary relative to the projection system in the plane perpendicular to the optical axis.

6. An apparatus according to any of claims 2 to 5, wherein said actuation means is part of said liquid supply system, the actuation means comprising:
a seal member extending along at least part of the boundary of said space between the final element of said projection system and said substrate table; and
a gas seal means for forming a gas seal between said seal member and the surface of said substrate; and wherein the pressure in said gas seal is varied to adjust the height and/or tilt of said liquid supply system relative to the substrate.

7. An apparatus according to claim 6, further comprising at least one sensor for measuring the position of the edge of said liquid relative to said gas seal means and a controller for varying said pressure in said gas seal means to influence said position of the edge of said liquid.

8. An apparatus according to claim 7, wherein said controller operates in a feedforward manner, based on the distance between said seal member and said substrate.

9. An apparatus of any preceding claim, wherein said part of said liquid supply system is braced away from said substrate table, preferably by a non-electrical mechanical or magnetic means.

10. An apparatus of any preceding claims, further comprising a safety controller which monitors the relative positions and/or velocity of said part of said liquid supply system and said substrate table.

11. An apparatus of preceding claims, further comprising a positional controller for generating control signals for positioning of said part of said liquid supply system in the direction of the optical axis.

12. An apparatus according to claim 11, wherein said positional controller is also for generating control signals for the positioning of said substrate table in the direction of the optical axis.

13. An apparatus according to claim 1, further comprising a control system for controlling said actuation means to maintain a predetermined height of at least part of said liquid supply system above said substrate.

14. An apparatus according to claim 13, further comprising at least one sensor for measuring a height of at least part of said liquid supply system above the surface of said substrate, and wherein said control system uses a feedback control method with input from said at least one sensor.

15. An apparatus according to claim 13, further comprising at least one sensor for measuring a height of said substrate in an exposure position, and wherein said control system uses a feedforward control method with input of said height of said substrate in an exposure position.
